# EUROPEAN PATENT SPECIFICATION

(11) **EP 1 901 110 B1**
(45) Date of publication and mention of the grant of the patent: **27.10.2010**
(21) Application number: 07016885.1
(22) Date of filing: 29.08.2007
(51) Int. Cl.: G02F 1/13, H05K 1/14, G02F 1/13357

(54) **Liquid crystal display**
Flüssigkristallanzeige
Affichage à cristaux liquides

(30) Priority: 15.09.2006 KR 20060089480
(43) Date of publication of application: 19.03.2008
(73) Proprietor: Samsung Electronics Co., Ltd., Yeongtong-gu Suwon-city, Gyeonggi-do 442-742 (KR)
(72) Inventor: Jang, Hyun-min, Seoul (KR)
(74) Representative: Dr. Weitzel & Partner

(56) References cited:
- EP-A- 0 911 678
- GB-A- 2 162 354
- US-A- 5 838 412
- US-A- 5 959 709
- US-A1- 2004 183 959
- US-A1- 2005 040 504
- US-B1- 6 297 868

## Description

### BACKGROUND OF THE INVENTION

### FIELD OF THE INVENTION

The present invention relates to a liquid crystal display device including a liquid crystal display panel that has printed circuit boards (PCBs) arranged along adjacent sides of the liquid crystal display panel.

### DISCUSSION OF THE BACKGROUND

In general, a liquid crystal display device displays a desired image on a liquid crystal display panel using light emitted from a backlight unit by adjusting the light transmittance of liquid crystal cells, which are arranged in the form of a matrix, according to an image signal.

A liquid crystal display device includes a liquid crystal display panel having liquid crystal cells that form pixels arranged in a matrix, a driving part that drives the liquid crystal cells, a driving circuit board having a circuit pattern formed to control the driving part, a backlight unit that supplies light to the liquid crystal display panel, and a bottom chassis that accommodates these components.

In such a liquid crystal display device, one end of the driving part may be connected to an electrode pad formed at a peripheral region of the liquid crystal display panel, extending to a lateral side of the liquid crystal display panel, and the driving circuit board may be connected to the other end of the driving part and is located at a rear surface of the bottom chassis. However, in recent years, the size of liquid crystal display devices has increased, causing the liquid crystal display device to become thicker and hence, the driving part to become longer. When the length of the driving part is increased, the manufacturing cost rises and workability in outer lead bonding (OLB) and module processes deteriorates.

In order to manufacture a liquid crystal display device without increasing the length of the driving part, the driving circuit board is separated into a first driving circuit board, which functions as a source PCB, and a second driving circuit board, which functions as a control PCB. The first driving circuit board may be connected to the other end of the driving part and is disposed along one side of the liquid crystal display panel, and the second driving circuit board is connected to the first driving circuit board via a flexible circuit board and is disposed at the rear surface of the bottom chassis.

In recent years, due to the diverse uses of liquid crystal display devices, the demand for multi-vision and dual monitors that display one picture using a plurality of interconnected liquid crystal display devices has increased.

If the circumferences of the plurality of liquid crystal display devices in a multi-vision or dual monitor are thick, the portion of the area occupied by the circumferences in the entire screen increases, resulting in deterioration of the picture quality. Accordingly, a liquid crystal display device having a narrow bezel with a thin circumference is desired.

In the related art, in order to protect the circuit components mounted on the first driving circuit board located at one lateral side of the liquid crystal display panel, a chassis is positioned so that there is a gap between the chassis and the circuit components. However, this results in a liquid crystal display panel having an increased circumference because of the thickness of the circuit components and the gap.

US 2004 0183959 A discloses a display device comprising the features of the preamble of claim 1. US 2005 0040504 A discloses a similar device with a double sided flexible circuit board for connecting the display panel to the circuit drivers.

### SUMMARY OF THE INVENTION

The present invention provides a liquid crystal display device having a narrow bezel in which the circumference of the liquid crystal display device is small.

Additional features of the present invention will be set forth in the description which follows and, in part, will be apparent from the description, or may be learned by practice of the present invention.

The present invention discloses a display device according to claim 1.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

FIG. 1 is an exploded perspective view of a liquid crystal display device according to an exemplary embodiment of the present invention.

FIG. 2 is a sectional view of the liquid crystal display device according to an exemplary embodiment of the present invention.

FIG. 3 is a perspective view of a rear side of the liquid crystal display device according to an exemplary embodiment of the present invention.

FIG. 4 is a block diagram of the liquid crystal display device according to an exemplary embodiment of the present invention.

FIG. 5 is a plan view showing coupling of a flexible circuit board.

FIG. 6 is a top plan view of the flexible circuit board.

FIG. 7 is a bottom plan view showing coupling of the flexible circuit board.

FIG. 8 is a bottom plan view of the flexible circuit board.

FIG. 9, FIG. 10, FIG. 11, and FIG. 12 are plan views of layers of the flexible circuit board.

FIG. 13 is a sectional view taken along line V-V' in FIG. 6.

### DETAILED DESCRIPTION OF THE ILLUSTRATED EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure is thorough and will fully convey the scope of the invention to those skilled in the art. In the drawings, the size and relative sizes of layers and regions may be exaggerated for clarity. Like reference numerals in the drawings denote like elements.

It will be understood that when an element or layer is referred to as being "on" or "connected to" another element or layer, it can be directly on or directly connected to the other element or layer, or intervening elements or layers may be present. In contrast, when an element is referred to as being "directly on" or "directly connected to" another element or layer, there are no intervening elements or layers present.

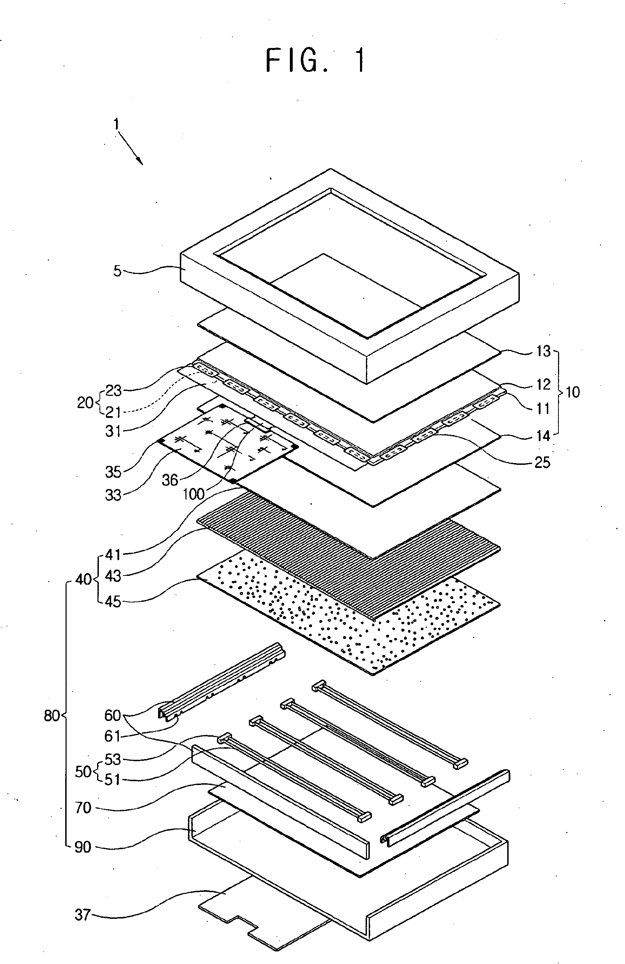

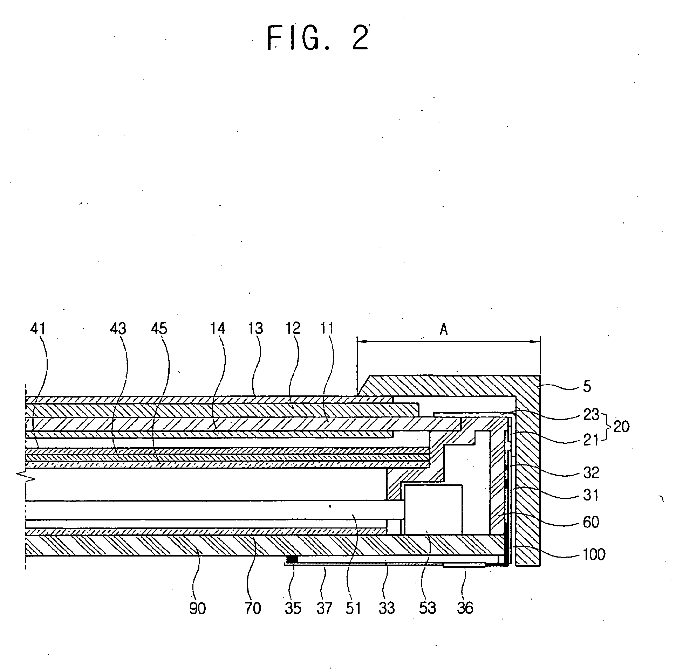

FIG. 1 is an exploded perspective view of a liquid crystal display device according to a first exemplary embodiment of the present invention, and FIG. 2 is a sectional view of the liquid crystal display device according to the first exemplary embodiment.

A liquid crystal display device 1 according to a first exemplary embodiment of the present invention includes a liquid crystal display panel 10 to display an image, a data driving part 20 to drive the liquid crystal display panel 10, a first driving circuit board 31 and a second driving circuit board 33 to control the data driving part 20, a flexible circuit board 100 connecting the first driving circuit board 31 and the second driving circuit board 33, a backlight unit 80 to emit light to a rear surface of the liquid crystal display panel 10, a mold frame 60 to support the circumference of the liquid crystal display panel 10, a bottom chassis 90 to accommodate the backlight unit 80 and the mold frame 60, and a top chassis 5 connected to the bottom chassis 90.

As shown in FIG. 2, the top chassis 5 protects the liquid crystal display panel 10 by surrounding the circumference of the liquid crystal display panel 10. The portion A indicated in FIG. 2 represents the circumference recognized by a user when the liquid crystal display device is driven.

The liquid crystal display panel 10 includes a thin film transistor substrate 11, a color filter substrate 12 facing the thin film transistor substrate 11, and a liquid crystal layer (not shown) interposed between the thin film transistor substrate 11 and the color filter substrate 12. The liquid crystal display panel 10 further includes polarizing plates 13 and 14 attached to the front surface of the color filter substrate 12 and the rear surface of the thin film transistor substrate 11, respectively, so that light passing through the liquid crystal display panel 10 can be cross-polarized. The liquid crystal display panel 10 has liquid crystal cells, as pixels, arranged in a matrix. The liquid crystal display panel 10 displays an image by controlling the light transmittance of the liquid crystal cells according to an image signal transmitted from the driving part 20.

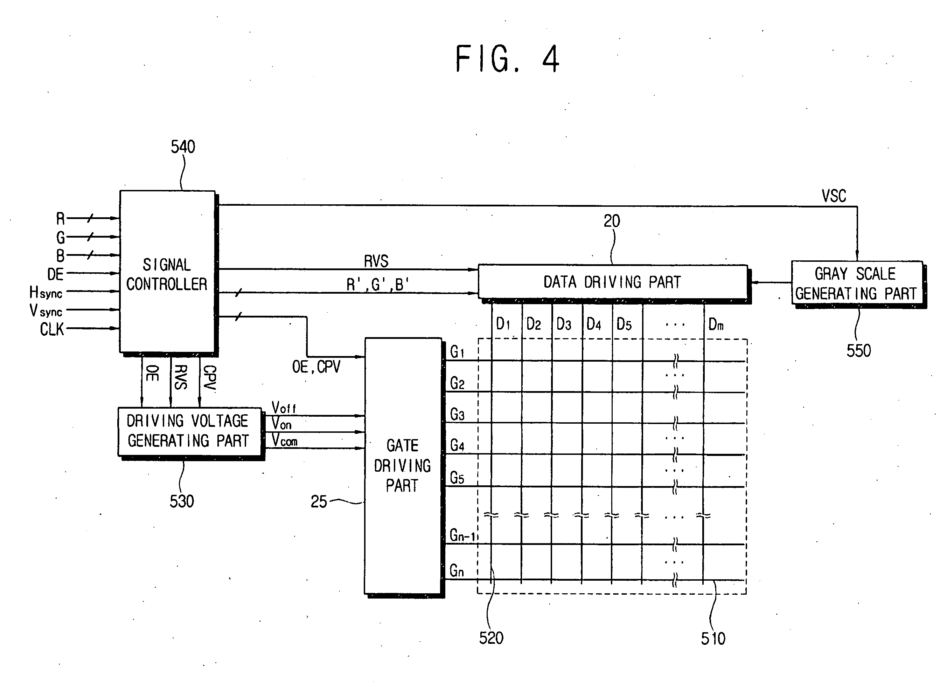

The thin film transistor substrate 11 has a plurality of gate lines 510 and a plurality of data lines 520, which are arranged in a matrix, and thin film transistors (TFTs) formed at crossings of the plurality of gate lines 510 and the plurality of data lines 520 (see FIG. 4). A signal voltage transmitted from the data driving part 20 may be applied between pixel electrodes of the thin film transistor substrate 11 and a common electrode of the color filter substrate 12, which will be described below, through the TFTs, and the liquid crystal molecules between the pixel electrodes and the common electrode are aligned according to the signal voltage, thereby adjusting the light transmittance of the liquid crystal layer.

The color filter substrate 12 includes red, green, and blue color filters or cyan, magenta, and yellow color filters, which may be repeatedly formed with black matrixes there between, and the common electrode. The common electrode may be formed of a transparent conductive material such as indium tin oxide (ITO) or indium zinc oxide (IZO). The color filter substrate 12 may have an area smaller than that of the thin film transistor substrate 11.

The data driving part 20 is provided in a chip-on-film (COF) manner and includes a driving chip 21 to apply a driving signal and a folded circuit film 23 on which the driving chip 21 is mounted. One portion of the folded circuit film 23 is connected to end portions of the data lines 520 of the thin film transistor substrate 11. The folded circuit film 23 of the data driving part 20 extends to a lateral side of the mold frame 60. Liquid crystal molecules interposed between the thin film transistor substrate 11 and the color filter substrate 12 may be aligned according to the driving signal from the data driving part 20. The data driving part 20 may be connected to the end portions of the data lines 520 along one side of the liquid crystal display panel. The data driving part 20, also called a source driver, receives a gray scale voltage from a gray scale voltage generating part 550 and applies the gray scale voltage to the data lines 520 under control of a signal controller 540, as shown in FIG. 4.

A gate driving part 25 connected to end portions of the gate lines 510 is connected to an adjacent side of the liquid crystal display panel 10. The gate driving part 25, which is provided in the same manner as the data driving part 20, receives signals and voltages, which are required to drive the liquid crystal display panel 10, from the driving circuit (the first and second driving circuit boards 31 and 33) via the data driving part 20. The gate driving part 25, also called a scan driver, is connected to the gate lines 510 and applies a gate signal, which is a combination of a gate ON voltage Vₒₙ and a gate OFF voltage V_{off} that are supplied from a driving voltage generating part 530, to the gate lines 510.

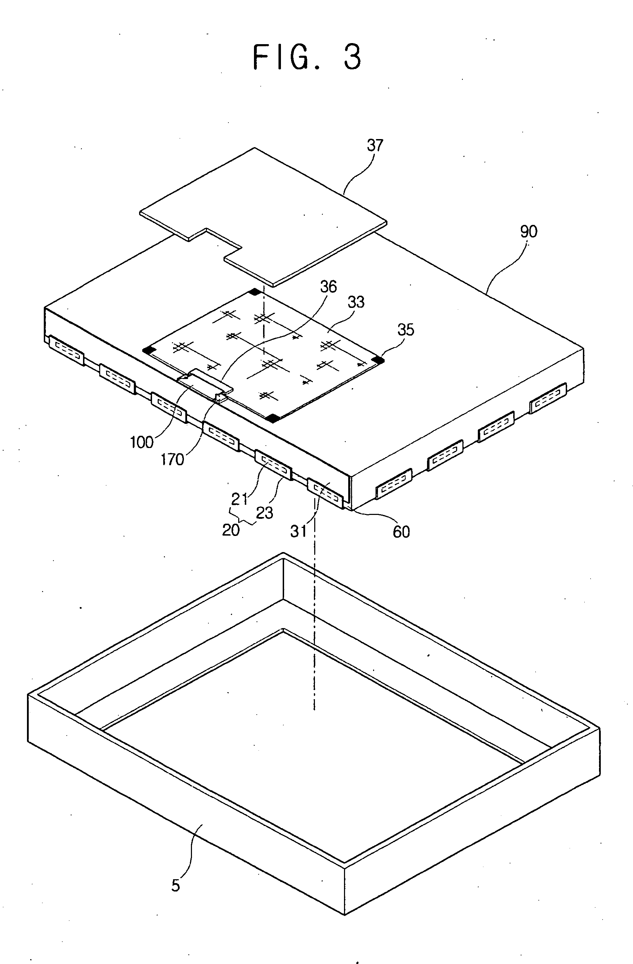

In this exemplary embodiment, as shown in FIG. 3, the driving circuit board is separated into a first driving circuit board 31 and a second driving circuit board 33. The first driving circuit board (source PCB) 31 is connected to the portion of the data driving part 20 that extends to a lateral side of the mold frame 60 and is disposed at one side of the mold frame 60. The second driving circuit board (control PCB) 33 is connected to the first driving circuit board 31 via the flexible circuit board 100 and is disposed at a rear surface of the bottom chassis 90.

A circuit pattern and various components that are connected to the circuit pattern and are required to control the data driving part 20 are mounted on the second driving circuit board 33. The second driving circuit board 33 is provided with a power connector (not shown) through which power is supplied externally, and a connector 36 to be connected to the flexible circuit board 100, which will be described below.

The second driving circuit board 33 includes the driving voltage generating part 530 and the signal controller 540. As shown in FIG. 4, the driving voltage generating part 530 generates the gate ON voltage Vₒₙ to turn on the TFTs as switching elements, the gate OFF voltage V_{off} to turn off the TFTs, a reference voltage (not shown), a common voltage V_{com} applied to the common electrode (not shown), etc. The signal controller 540 generates control signals that control operations of the gate driving part 25, the data driving part 20, the driving voltage generating part 530, the gray scale voltage generating part 550, etc., and supplies the generated control signals to these components.

The control signals and voltages generated in the second driving circuit board 33 are supplied to the first driving circuit board 31 via the flexible circuit board 100. The first driving circuit board 31 converts the control signals supplied from the second driving circuit board 33 into signals suitable for controlling the data and gate driving parts 20 and 25. For example, as shown in FIG. 4, the first driving circuit board 31 transmits the gate ON voltage Vₒₙ, the gate OFF voltage V_{off}, and the common voltage V_{com}, which are received from the second driving circuit board 33, to the driving parts 20 and 25, and the gray scale voltage generating part 550 of the first driving circuit board 31 converts the reference voltage into a gamma voltage (gray scale voltage) to be supplied to the data driving part 20. The gray scale voltage generating part 550 generates a plurality of gray scale voltages related to luminance of the liquid crystal display device 1 using the reference voltage.

Alternatively, the second driving circuit board 33 may be provided with the gray scale voltage generating part 550 that converts the reference voltage into a gamma voltage (gray scale voltage) to be supplied to the first driving circuit board 31.

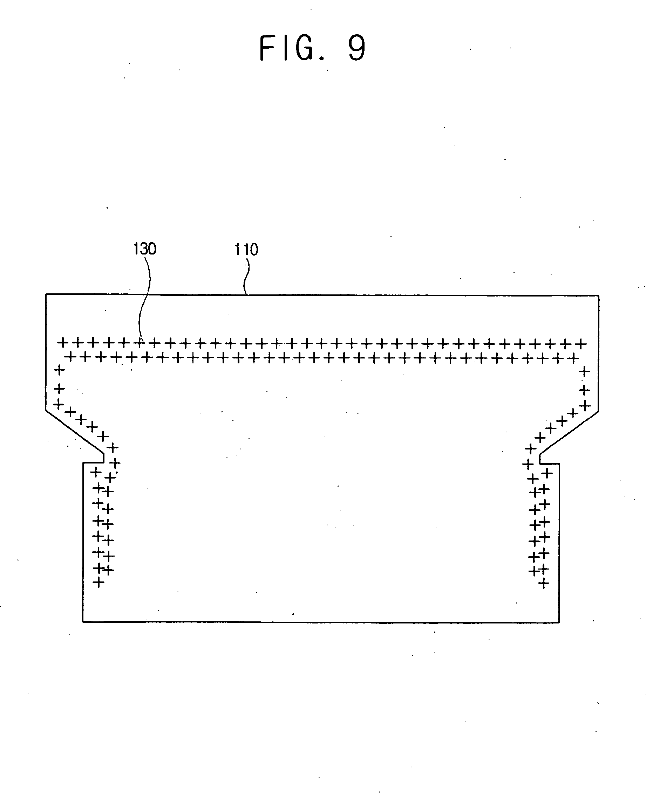

A ground terminal 35 that grounds the second driving circuit board 33 to the bottom chassis 90 is provided at an edge of the second driving circuit board 33. The ground terminal 35 may be made of conductive material, such as copper, and serves to reduce electromagnetic interference (EMI) occurring in the second driving circuit board 33. A ground wiring line 130 (see FIG. 9) of the flexible circuit board 100, to be described below, may be connected to the ground terminal 35 of the second driving circuit board 33.

In addition, in this exemplary embodiment, the liquid crystal display device 1 further includes a circuit protecting plate 37 that blocks EMI occurring in the second driving circuit board 33 while protecting the second driving circuit board 33. The circuit protecting plate 37 is coupled to the bottom chassis 90, covering the second driving circuit board 33.

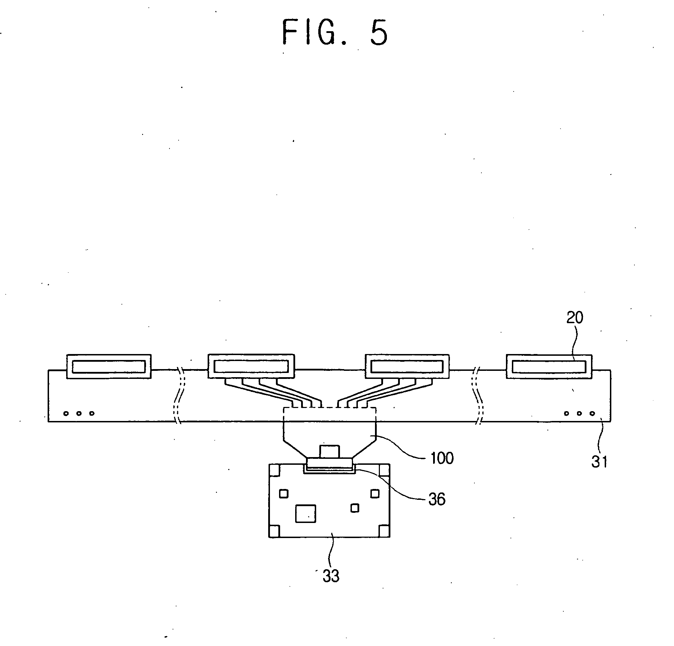

FIG. 5 shows the coupling of the flexible circuit board 100 between the first and second driving circuit boards 31 and 33. As shown in FIG. 5, the flexible circuit board 100 may be coupled to the bottom of the first driving circuit board 31. Circuit wiring lines of the flexible circuit board 100 may be connected to circuit wiring lines of the first driving circuit board 31 by solder or the like. A lower portion of the flexible circuit board 100 may be inserted into the connector 36 of the second driving circuit board 33.

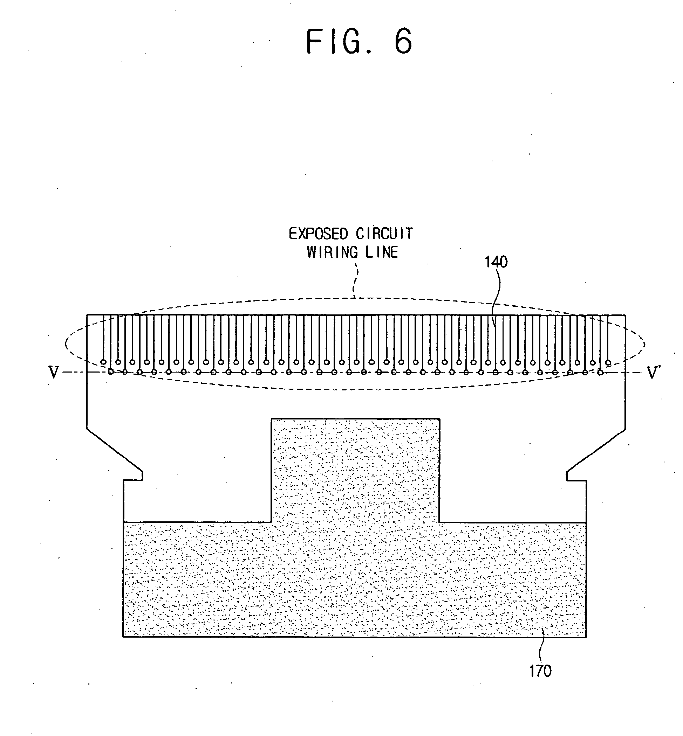

FIG. 6 is a plan view of the flexible circuit board 100. The flexible circuit board 100 has circuit wiring lines exposed when viewed from the top of the flexible circuit board 100, as shown in FIG. 6. The circuit wiring lines that are not covered by a coating layer contact the circuit wiring lines of the first driving circuit board 31 providing for an exchange of electrical signals there between.

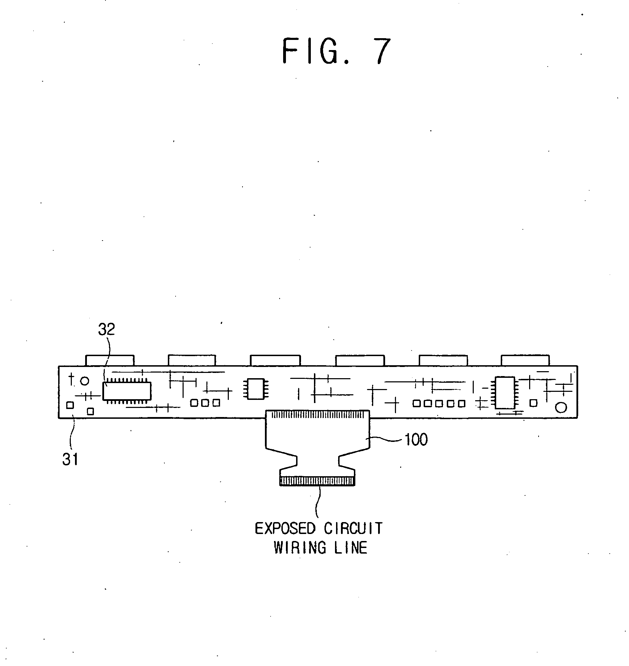

FIG. 7 is a rear side plan view showing coupling between the first driving circuit board 31 and the flexible circuit board 100. As shown in FIG. 7, various circuit components 32 are arranged on a rear side of the first driving circuit board 31. Referring to FIG. 2 and FIG. 3, the circuit components 32 arranged on the rear surface of the first driving circuit board 31 contact the mold frame 60 and are located at a lateral side of the liquid crystal display panel 10.

The exposed circuit wiring lines of the flexible circuit board 100 are connected to the circuit wiring lines formed on the lower part of the first driving circuit board 31. Also, a lower portion of the flexible circuit board 100 has exposed circuit wiring lines, which may be connected to the connector 36 of the second driving circuit board 33.

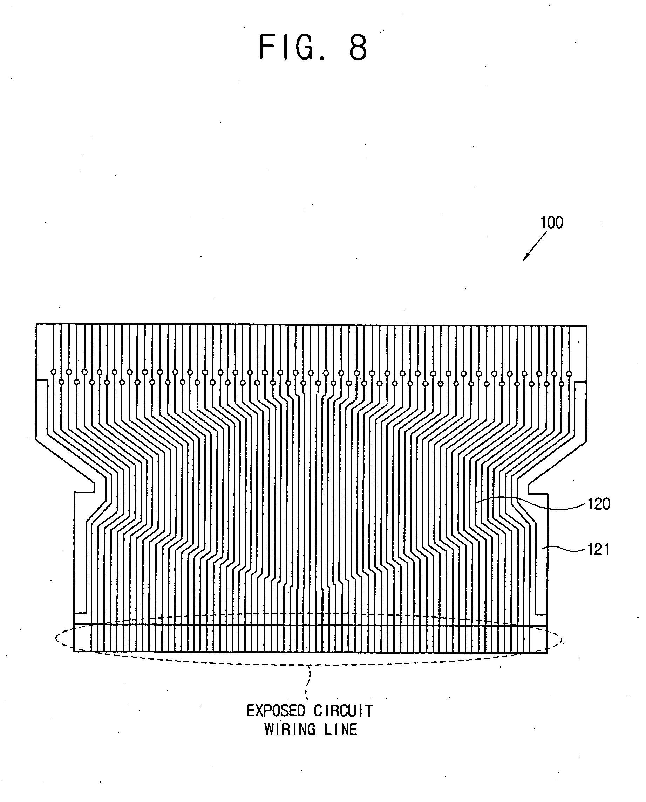

As shown in FIG. 6 and FIG. 8, the circuit wiring lines are exposed on an upper portion of the top of the flexible circuit board 100 and a lower portion of the bottom of the flexible circuit board 100. The flexible circuit board 100 has such a circuit wiring line configuration because the circuit components 32 of the first driving circuit board 31 are arranged in the lower portion of the first driving circuit board 31. This configuration allows the circumference A of the liquid crystal display device to be thinner.

The detailed configuration of the flexible circuit board 100 is described through plan views of layers of the flexible circuit board 100.

FIG. 9, FIG. 10, FIG. 11, and FIG. 12 are plan views of layers of the flexible circuit board 100.

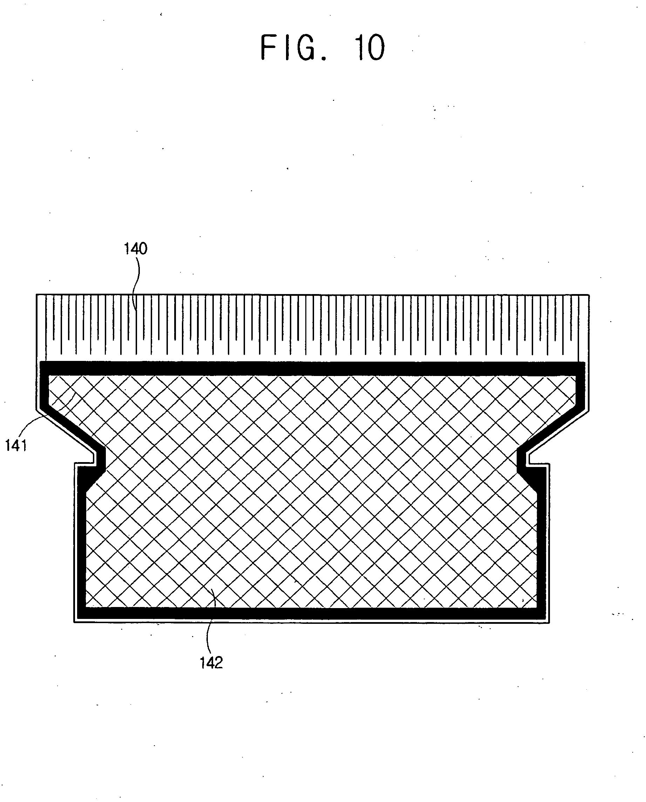

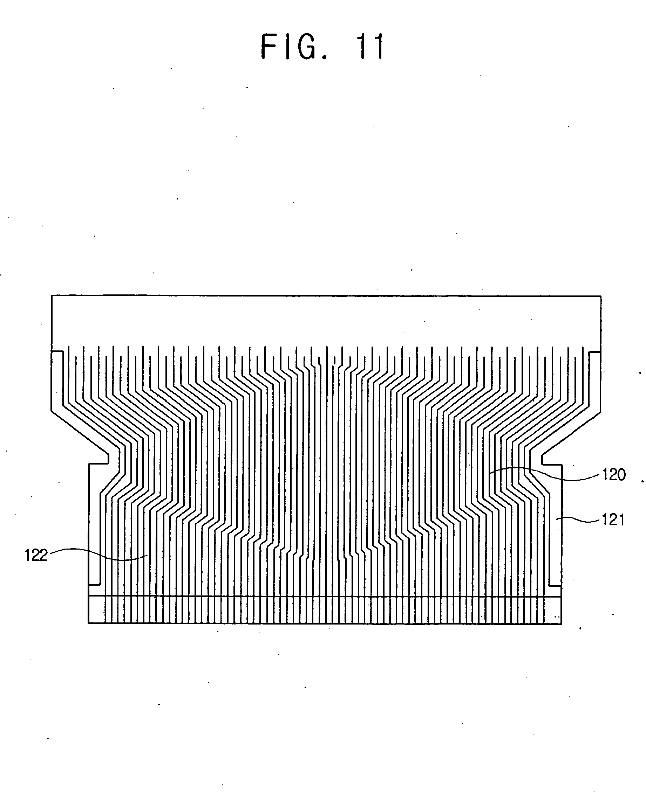

First, a planar structure of an insulating film 110 will be described with reference to FIG. 9. The insulating film 110 forms a middle layer of the flexible circuit board 100 and serves to support circuit wiring lines. The insulating film 110 has a plurality of contact holes 130. Although indicated by "+" in the figure, each contact hole 130 may have a circular shape. Referring to FIG. 10 and FIG. 11, upper circuit wiring lines 140 are connected to lower circuit wiring lines 120 via the contact holes 130. Of the plurality of contact holes 130, contact holes 130 arranged in line allow the upper circuit wiring lines 140 to connect to the lower circuit wiring lines 120, and contact holes 130 located at a lateral side of the insulating film 110 allow the ground wiring lines to connect to one another.

FIG. 10 shows a plan view of an upper circuit wiring line layer. The upper circuit wiring lines 140 are connected to the lower circuit wiring lines 120 via the contact holes 130 of the insulating film 110. The upper circuit wiring lines 140 are formed at an upper portion of the flexible circuit board 100. An electrical signal from the second driving circuit board 33 is transmitted to the first driving circuit board 31 through the lower circuit wiring lines 120, the contact holes 130, and the upper circuit wiring lines 140. Accordingly, the upper circuit wiring lines 140 are arranged only on the upper portion of the upper circuit wiring line layer. Upper ground wiring lines 141 may be formed of the same material and at the same layer as the upper circuit wiring lines 140 of FIG. 10 and are arranged in a lower portion of the flexible circuit board 100. The upper ground wiring lines 141 having a net wiring line structure are connected to a ground terminal 35 connected to the connector 36 of the second driving circuit board 33, thereby forming a closed circuit in which the internal circuit of the second driving circuit board 33 is connected to the bottom chassis 90.

With this configuration of the flexible circuit board 100, the ground wiring lines 141, which have a high voltage and are disposed in the closed circuit, are connected (i.e., grounded) to the bottom chassis 90, thereby drawing out and reducing EMI occurring in the flexible circuit board 100. That is, even if a high voltage is used and the driving frequency is increased, the configuration of the ground wiring lines 141 of the flexible circuit board 100 allows the EMI occurring in the flexible circuit board 100 to be reduced.

FIG. 11 shows a plan view of a lower circuit wiring line layer 120. Unlike the upper circuit wiring lines 140, the lower circuit wiring lines 120 are not located in the upper portion of the flexible circuit board 100. Rather, the lower circuit wiring lines 120 are located in the center of the flexible circuit board 100, and the lower ground wiring lines 121 are located along an edge of the flexible board 100. The lower circuit wiring lines 120 are connected to the upper circuit wiring lines via the contact holes 130 of the insulating film 110. In addition, the lower ground wiring lines 121 also are connected to the upper ground wiring lines 141 via the contact holes 130.

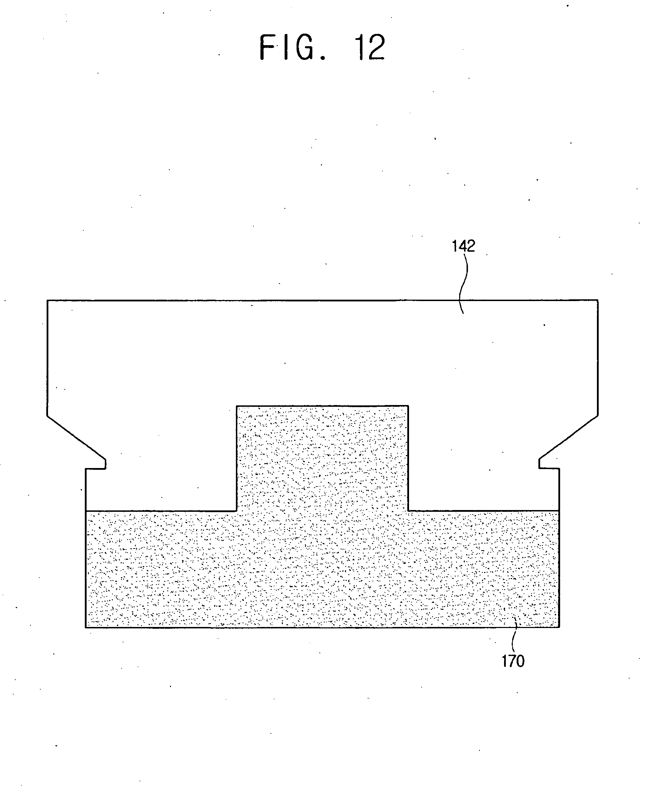

FIG. 12 shows a plan view of a reinforcement film 170. The upper circuit wiring line layer is covered by an insulating coating layer 142 that protects the circuit wiring lines. The reinforcement film 170 may be attached to the insulating coating layer 142. The reinforcement film 170 also protects the circuit wiring lines and may be used to distinguish the use of each flexible circuit board 100. In addition, a portion of the enhancement film 170 does not contact the flexible circuit board 100, thereby providing good workability.

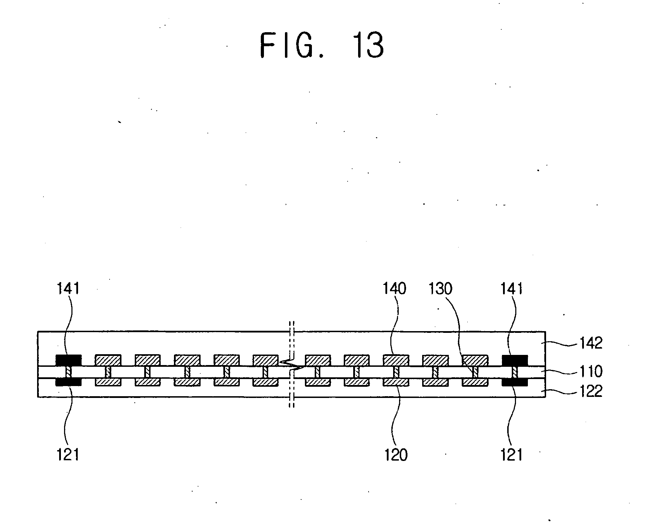

FIG. 13 shows a sectional view of the flexible circuit board 100.

FIG. 13 is a sectional view taken along line V-V' in FIG. 6. As shown in the figure, the flexible circuit board 100 includes the insulating film 110, the upper circuit wiring lines 140 formed on one side of the insulating film 110, the lower circuit wiring lines 120 formed on the opposite side of the insulating film 110, an upper insulating coating layer 142 covering the upper circuit wiring lines 140, a lower insulating coating layer 122 covering the lower circuit wiring lines 120, and the plurality of contact holes 130 that connects the upper circuit wiring lines 140 and the lower circuit wiring lines 120. The upper ground wiring lines 141 may be made of the same material as the upper circuit wiring lines 140 and also may be connected to the lower ground wiring lines 121 via the contact holes 130.

The insulating coating layers 122 and 142 of the flexible circuit board 100 expose some of the lower circuit wiring lines 120 and some of the upper circuit wiring lines 140, respectively. The exposed circuit wiring lines contact the circuit wiring lines of the first driving circuit board 31 and the connector of the second driving circuit board 33. As shown in FIG. 6, tops of the upper circuit wiring lines 140 are exposed without being covered by the insulating coating layer 142. The exposed circuit wiring lines 140 are connected to the circuit wiring lines of the first driving circuit board 31 by solder or the like. In addition, as shown in FIG. 8, the bottoms of the lower circuit wiring lines 120 are exposed without being covered by the insulating coating layer 122. The exposed circuit wiring lines 120 are connected to the connector 36 of the second driving circuit board 33.

A flexible circuit board may connect a first driving circuit board and a second driving circuit board by exposing upper and lower portions of circuit wiring lines, formed as a single-layered structure on an insulating film, at a rear side (bottom) of the flexible circuit board. In the present invention, however, in a case where the circuit components 32 of the first driving circuit board 31 are arranged toward the mold frame 60, the first driving circuit board 31 is connected to the second driving circuit board 33 with some of the circuit wiring lines being exposed on the top (front side) and bottom (rear side) of the flexible circuit board 100. Accordingly, since the first driving circuit board 31 may be inwardly mounted in the mold frame, the width of the circumference A of the liquid crystal display device 1 may be reduced in an amount equal to the height of the circuit components 32. To achieve such a structure, the flexible circuit board 100 that should include the upper circuit wiring lines 140 and the lower circuit wiring lines 120 that connect the first driving circuit board 31 and the second driving circuit board 33, providing for the exchange of electrical signals there between.

Referring to FIG. 1 again, the backlight unit 80 located below the liquid crystal display panel 10 includes optical sheets 40, a light source part 50, and a reflecting sheet 70.

The optical sheet 40 includes a protection sheet 41, a prism sheet 43, and a diffusion sheet 45, all of which are located below the liquid crystal display panel 10.

The light source part 50 includes a plurality of light sources 51 that emit light, and light source electrodes (not shown) formed at end portions of the light sources 51 and supplied with power from an inverter (not shown). The light sources 51 are arranged in parallel below the liquid crystal display panel 10, with the end portions of pairs of light sources 51 being inserted into light source holders 53. The light sources 51 may generally include cold cathode fluorescent lamps (CCFLs) or external electrode fluorescent lamps (EEFLs).

The mold frame 60 may have a two-stepped hollow shape and may be disposed at a lateral side of the bottom chassis 90. The mold frame 60 has insertion grooves 61 to which the light sources 51 are coupled and in which the light source holders 53 are accommodated. Edges of the optical sheets 40 are supported by a first step of the mold frame 60 and an edge of the liquid crystal display panel 10 is supported by a second step of the mold frame 60. The liquid crystal display panel 10 is isolated from the backlight unit 80 by the mold frame 60.

The reflecting sheet 70 is located by the light sources 51 and the bottom chassis 90 and serves to reflect light from the light sources 51 toward the diffusion film 45. The reflecting sheet 70 may include such material as polyethylene terephthalate (PET) or polycarbonate (PC). The reflecting sheet 70 may contribute to a reduction of light loss and an improvement of uniformity of light emitted toward the liquid crystal display panel 10 by reflecting light traveling in a direction away from the liquid crystal display panel 10 back toward the liquid crystal display panel 10. The reflecting sheet 70 is attached to the bottom of the bottom chassis 90.
The top chassis 5 has a display window that exposes a display region of the liquid crystal display panel 10 outwardly, and is coupled to the bottom chassis 90.
The bottom chassis 90 accommodates the backlight unit 80 and is coupled to the top chassis 5.
As apparent from the above description, in the liquid crystal display device of the present invention, since circuit components of the first driving circuit board contact the mold frame, there is no need for a separate member to protect the circuit components. Accordingly, the thickness of the circumference of the liquid crystal display device may be further decreased. Thus, it is intended that the present invention cover the modifications and variations of this invention provided they come within the scope of the appended claims.

## Claims

1. A display device (1), comprising:
a display panel (10) provided with an electrode pad;
a light source (50) to emit light to the display panel (10);
a mold frame (60) to support the light source (50);
a bottom chassis (90) to accommodate the mold frame (60);
a driving part (20) to apply a driving signal to the display panel (10), the driving part (20) being connected to the electrode pad and comprising a driving chip (21) to apply the driving signal;
a driving circuit part to control the driving part (20) and comprising:
a first driving circuit board (31) connected to the driving part (20) **characterised in that** the driving circuit part further comprises
a second driving circuit board (33) connected to the first driving circuit board (31);
circuit components (32) mounted on the first driving circuit board (31) which face the lateral side of the mold frame (60); and
a flexible circuit board (100) to connect the first driving circuit board (31) to the second driving circuit board (33).

2. The display device (1) of claim 1, wherein the flexible circuit board (100) comprises:
an insulating film (110) comprising a plurality of contact holes (130),
a first circuit wiring line (120) disposed on one side of the insulating film (110),
a second circuit wiring line (140) disposed on the other side of the insulating film (110), and
a coating layer (122; 142) disposed on at least one side of the insulating film (110) and coated on the circuit wiring line on the at least one side, wherein the first circuit wiring line (120) and the second circuit wiring line (140) are connected together via the contact holes (130).

3. The display device (1) of claim 2, wherein a part of the first circuit wiring line (120) is not coated by the coating layer (122).

4. The display device (1) of claim 2, wherein a part of the second circuit wiring line (140) is not coated by the coating layer (142).

5. The display device (1) of claim 2, wherein the first circuit wiring line (120) is connected to a lower portion of the first driving circuit board (31) where the circuit components are mounted.

6. The display device (1) of claim 2, wherein the first circuit wiring line (120) is connected to a lower portion of the first driving circuit board (31) where the circuit components are mounted, and a connector (36) and circuit components are mounted on a upper portion of the second driving circuit board (33) and the second circuit wiring line (140) is connected to the connector (36).

7. The display device (1) of claim 2, wherein the flexible circuit board (100) further comprises a ground wiring line (130).

8. The display device (1) of claim 1, wherein the first driving circuit board (31) Is disposed on one lateral side of the mold frame (60), and the second driving circuit board (33) is disposed on the bottom chassis (90).

9. The display device (1) of claim 1, wherein
the bottom chassis (90) is adapted to accommodate the display panel (10);
the first driving circuit board (31) is adapted to control the driving part (20) and the circuit components
the second driving circuit board (33) is located at a rear surface of the bottom chassis (90).

## Patentansprüche

1. Anzeigevorrichtung (1), die Folgendes umfasst:
ein Anzeigefeld (10), das mit einem Elektrodenfleck versehen ist;
eine Lichtquelle (50) zum Abgeben von Licht an die Anzeigevorrichtung (10);
einen Formrahmen (60) zum Halten der Lichtquelle (50);
ein Boden-Chassis (90) zur Aufnahme des Formrahmens (60);
ein Steuerteil (20) zum Anlegen eines Steuersignals an das Anzeigefeld (10), wobei das Steuerteil (20) mit dem Elektrodenfleck verbunden ist und einen Steuerchip (21) zum Anlegen des Steuersignals umfasst;
ein Steuerschaltteil zur Steuerung des Steuerteils (20), Folgendes umfassend:
eine erste Steuerschaltplatte (31), die mit dem Steuerteil (20) verbunden ist,
**dadurch gekennzeichnet, dass** das Steuerschaltteil ferner eine zweite Steuerschaltplatte (33) umfasst, die mit der ersten Steuerschaltplatte (31) verbunden ist;
Schaltbauteile (32), die an der ersten Steuerschaltplatte (31) montiert sind, welche der seitlichen Seite des Formrahmens (60) zugewandt sind, und eine flexible Schaltplatte (100) zur Verbindung der ersten Steuerschaltplatte (31) mit der zweiten Steuerschaltplatte (33).

2. Anzeigevorrichtung (1) gemäß Anspruch 1, wobei die flexible Schaltplatte (100) umfasst:
einen Isolierfilm (110), der eine Mehrzahl von Kontaktlöchern (130) umfasst,
eine erste Schaltverdrahtungsleitung (120), die auf einer Seite des Isolierfilms (110) angeordnet ist,
eine zweite Schaltverdrahtungsleitung (140), die auf der anderen Seite des Isolierfilms (110) angeordnet ist, und
eine Deckschicht (122; 142), die auf wenigstens einer Seite des Isolierfilms (110) angeordnet und auf der Schaltverdrahtungsleitung auf der wenigstens einen Seite aufgebracht ist, wobei die erste Schaltverdrahtungsleitung (120) und die zweite Schaltverdrahtungsleitung (140) über die Kontaktlöcher (130) miteinander verbunden sind.

3. Anzeigevorrichtung (1) gemäß Anspruch 2, wobei ein Teil der ersten Schaltverdrahtungsleitung (120) nicht von der Deckschicht (122) abgedeckt ist.

4. Anzeigevorrichtung (1) gemäß Anspruch 2, wobei ein Teil der zweiten Schaltverdrahtungsleitung (140) nicht von der Deckschicht (142) abgedeckt ist.

5. Anzeigevorrichtung (1) gemäß Anspruch 2, wobei die erste Schaltverdrahtungsleitung (120) an einen unteren Abschnitt der ersten Steuerschaltplatte (31) angeschlossen ist, wo die Schaltbauteile montiert sind.

6. Anzeigevorrichtung (1) gemäß Anspruch 2, wobei die erste Schaltverdrahtungsleitung (120) an einen unteren Abschnitt der ersten Steuerschaltplatte (31) angeschlossen ist, wo die Schaltbauteile montiert sind, und ein Stecker (36) und Schaltbauteile an einem oberen Abschnitt der zweiten Steuerschaltplatte (33) montiert sind und die zweite Schaltverdrahtungsleitung (140) mit dem Stecker (36) verbunden ist.

7. Anzeigevorrichtung (1) gemäß Anspruch 2, wobei die flexible Schaltplatte (100) ferner eine Erdverdrahtungsleitung (130) umfasst.

8. Anzeigevorrichtung (1) gemäß Anspruch 1, wobei die erste Steuerschaltplatte (31) auf einer seitlichen Seite des Formrahmens (60) angeordnet ist und die zweite Steuerschaltplatte (33) auf dem Bodenchassis (90) angeordnet ist.

9. Anzeigevorrichtung (1) gemäß Anspruch 1, wobei das Bodenchassis (90) dazu ausgeführt ist, das Anzeigefeld (10) aufzunehmen;
wobei die erste Steuerschaltplatte (31) dazu ausgeführt ist, das Steuerteil (20) und die Schaltbauteile zu steuern;
wobei die zweite Steuerschaltplatte (33) auf einer Rückseite des Bodenchassis (90) angeordnet ist.

## Revendications

1. Un dispositif d'affichage (1) comprenant :
un panneau d'affichage (10) fourni avec une électrode ;
une source lumineuse (50) pour émettre de la lumière sur le panneau d'affichage (10) ;
un cadre de moule (60) pour soutenir la source lumineuse (50) ;
un châssis inférieur (90) pour recevoir le cadre de moule (60) ;
un mécanisme d'entraînement (20) pour appliquer un signal d'entraînement au panneau d'affichage (10), le mécanisme d'entraînement (20) étant connecté à l'électrode et comprenant une puce d'entraînement (21) pour appliquer le signal d'entraînement ;
un mécanisme de circuit d'entraînement pour contrôler le mécanisme d'entraînement (20) et comprenant :
une première carte de circuit d'entraînement (31) connectée au mécanisme d'entraînement (20), **caractérisée en ce que** le mécanisme de circuit d'entraînement comprend également
une deuxième carte de circuit d'entraînement (33) connectée à la première carte de circuit d'entraînement (31) ;
des composants de circuit (32) montés sur la première carte de circuit d'entraînement (31) qui sont face au côté latéral du cadre de moule (60) ; et
une carte de circuit flexible (100) pour connecter la première carte de circuit d'entraînement (31) à la deuxième carte de circuit d'entraînement (33)

2. Le dispositif d'affichage (1) de la revendication 1, où la carte de circuit flexible (100) comprend :
un film d'isolation (110) comprenant une pluralité d'orifices de contact (130),
une première ligne de câblage de circuit (120) disposée sur un côté du film d'isolation (110),
une deuxième ligne de câblage de circuit (140) disposée sur l'autre côté du film d'isolation (110), et
une couche de revêtement (122 ; 142) disposée sur au moins un côté du film d'isolation (110) et recouvrant la ligne de câblage de circuit sur au moins un côté, où la première ligne de câblage de circuit (120) et la deuxième ligne de câblage de circuit (140) sont connectées ensemble au travers des orifices de contact (130).

3. Le dispositif d'affichage (1) de la revendication 2, où une partie de la première ligne de câblage du circuit (120) n'est pas recouverte par la couche de revêtement (122).

4. Le dispositif d'affichage (1) de la revendication 2, où une partie de la deuxième ligne de câblage du circuit (140) n'est pas recouverte par la couche de revêtement (142).

5. Le dispositif d'affichage (1) de la revendication 2, où la première ligne de câblage du circuit (120) est connectée à une partie inférieure de la première carte du circuit d'entraînement (31) où les composants du circuit sont montés.

6. Le dispositif d'affichage (1) de la revendication 2, où la première ligne de câblage du circuit (120) est connectée à une partie inférieure de la première carte du circuit d'entraînement (31) où les composants du circuit sont montés, et un connecteur (36) et des composants du circuit sont montés sur une partie supérieure de la deuxième carte du circuit d'entraînement (33) et la deuxième ligne de câblage du circuit (140) est connectée au connecteur (36).

7. Le dispositif d'affichage (1) de la revendication 2, où la carte de circuit flexible (100) comprend également une ligne de câblage à la terre (130).

8. Le dispositif d'affichage (1) de la revendication 1, où la première carte de circuit d'entraînement (31) est disposée sur un côté latéral du cadre de moule (60) et la deuxième carte de circuit d'entraînement (33) est disposée sur le châssis inférieur (90).

9. Le dispositif d'affichage (1) de la revendication 1, où le châssis inférieur (90) est adapté pour recevoir le panneau d'affichage (10) ;
la première carte de circuit d'entraînement (31) est adaptée pour contrôler le mécanisme d'entraînement (20) et les composants du circuit la deuxième carte de circuit d'entraînement (33) est située sur une surface arrière du châssis inférieur (90).
